# EUROPEAN PATENT SPECIFICATION

(11) **EP 0 696 761 B1**
(45) Date of publication and mention of the grant of the patent: **08.04.1998**
(21) Application number: 95202170.7
(22) Date of filing: 09.08.1995
(51) Int. Cl.: G03F 7/038, G03F 7/033

(54) **Flexographic printing plates from photocurable elastomer compositions**
Flexodruckplatten aus fotohärtbarem Elastomerzusammensetzungen
Plaques d'impression flexographique préparées à partir de compositions élastomériques photodurcissables

(30) Priority: 10.08.1994 EP 94202298
(43) Date of publication of application: 14.02.1996
(73) Proprietor: SHELL INTERNATIONALE RESEARCH MAATSCHAPPIJ B.V., 2596 HR Den Haag (NL)
(72) Inventor: Mayenez, Catherine, B-1348 Ottignies Louvain-la-Neuve (BE); Muyldermans, Xavier, B-1348 Ottignies Louvain-la-Neuve (BE)

(56) References cited:
- WO-A-93/24547
- DATABASE WPI Section Ch, Week 8819 Derwent Publications Ltd., London, GB; Class A89, AN 88-128571 & JP-A-63 070 242 ( NIPPON ZEON KK) , 30 March 1988

## Description

The present invention relates to flexographic printing plates derived from photocurable elastomer compositions, and more in particular from photocurable elastomer compositions comprising at least one block copolymer, derived from at least a poly(monovinylaromatic) block and a poly(conjugated diene) block, and at least one photoinitiator.

Said printing plates, also called flexo plates, are especially useful for commercial printing and packaging of diverse products such as frozen food bags, orange juice cartons, potato chips bags, boxes and envelopes.

Photocurable polymer compositions are well known in the art for forming printing plates and other radiation sensitive articles.

In the field of flexographic printing plates the plates typically comprise a support and a photosensitive layer prepared from the photocurable composition.

Additional layers on the plate include slip and release films to protect the photosensitive surface. Prior to processing the plate, the additional layers are removed and the photosensitive layer is exposed to radiation in an imagewise fashion. The unexposed areas of the layer are then removed in developer baths.

Photosensitive layers of photocurable compositions for the preparation of flexographic printing plates, often have been described in a widely diverging array of types, such as those in German patent application Nos. 2138582, 2223803, 2364873, 2610206, 2631837, 2720228, 2815678; US patents Nos. 2,760,863, 2,948,611, 3,024,180, 3,674,486, 3,798,035 and 3,951,657, 4,023,973, 4,762,892, and 5,250,389; European patent application Nos. 0,219,795, 0,422,488, 0,467,135, 0,553,662 and Japanese patent applications Nos. 59142538, 61098344, 63161443 and 63309568.

However, those photocurable polymer compositions as specified therein, have appeared to leave a need for further improvement to provide practically acceptable irradiation exposing times in combination with the relief depth as presently required by the printing industry in combination with a relatively low hardness and preferably without using any toxic ethylenic unsaturated compounds at all or only at very small not earlier used concentrations.

Moreover, there is still existing a need for further improvement of the total combination of relevant physical properties of such photocurable compositions for printing plates.

In addition to possessing an easily developable less dangerous photosensitive layer, a flexographic printing plate must be flexible enough to wrap around a printing cylinder, strong enough to withstand the rigors experienced during typical printing process, soft enough to facilitate ink transfer during printing process and resistant enough to the particular ink solvent to avoid blurring of the image. On the other hand it is important that the photosensitive layer of the printing plate be dimensionally stable during storage. Some compositions earlier proposed for making printing plates, have shown inferior stability properties, in that the compositions become tacky and pasty.

It will be appreciated that the achievement of an attractive balance of all these physical properties will be difficult.

Japanese patent application publication no. JP-A-63070242 describes a photosensitive elastomer composition for use in flexographic printing plates. The elastomer composition can be represented by the formula (AB)ₙX, wherein A is a polymer block of styrene or alkylstyrene, B is a polymer block of butadiene, isoprene and the like, preferably isoprene, n typically ranges from 3 to 10 and X is a polyfunctional coupling agent. The photosensitive elastomer composition comprises a photoinitiator which may be benzophenone.

As can be derived from e.g. European patent application no. 0525206, more recently attempts to develop an improved combination of desired properties of photocurable polymer compositions and flexographic printing plates derived therefrom, were directed to the use of thermoplastic block copolymers, comprising
(1) at least one predominantly monovinyl substituted aromatic hydrocarbon polymer block and at at least one predominantly conjugated dienepolymer block, said block copolymer having a monovinyl substituted aromatic hydrocarbon content (A) of 10 to 35 wt%, and said conjugated diene having a vinyl content (V) of 20 to 50%, and the sum of (A) + (V) being in the range of from 40% to 70%
(2) and 1 to 20 wt%, based on the weight of the elastomer composition of an ethylenically unsaturated compound as a photocuring auxiliary; and
(3) 0, 1 to 3 wt% based on the weight of the elastomer composition, of a photopolymerization initiator
As component (2) was used a member selected from the group consisting of an acrylate a methacrylate, a maleimide or diesters of maleci acid or fumaric acid, which still represent a toxic and/or expensive auxiliary.

From European patent application no. 0543632 were known photocurable polymer compositions and flexographic printing plates derived therefrom, comprising random copolymers of various acrylates and conjugated dienes or triblock copolymers, comprising at least a polymer segment of a C₂-C₅-alkyl methacrylate or methacrylic acid and at least a polymer segment of a conjugated diene.

Accordingly, an object of the present invention is formed by an easily developable, photo cured flexographic printing plate, showing a decreased hardness and preferably without the use of toxic and/or expensive photocuring auxiliaries.

More in particular it is an object of the invention to prepare a solid photosensitive layer which is flexible, yet strong and durable, which has a relatively low hardness and can be obtained preferably without said additional photocurable auxiliaries.

It is also an object to prepare a solid photosensitive layer which, when cured in an imagewise pattern, results in a relief pattern layer which easily and clearly transfer ink in instances the layer is that of a flexible printing plate.

A particular object of the present invention is to provide flexographic printing plates from photocurable block copolymer containing compositions, which can be achieved by improved irradiation exposure times during the usual manufacture of flexographic printing plates, without any deterioration of the other properties of the photocurable compositions during the manufacture of the relief form and with more attractive hardness.

More in particular these compositions aimed at should provide an attractive visual appreciation system for a pictural irradiated form before the development step by changing the absorption behaviour. More preferably these compositions aimed at should be substantially free or almost free of the usually applied additional crosslinking monomer.

As a result of extensive research and experimentation such a flexographic printing plates aimed at have now been surprisingly found.

Accordingly one aspect of the present invention is relating to flexographic printing plates obtainable by exposing to UV irradiation a photocurable elastomer composition, comprising at least
(a) 100 parts by weight (pbw) of a block copolymer containing at least three poly(conjugated diene) blocks and at least one block selected from poly(monovinylaromatic) block, and having a branched or radial structure, of the general formula [AB]ₚ [C]_{q}X; wherein each A represents a predominantly poly(monovinyl- aromatic) block, B and C represent a predominantly poly(conjugated diene) and preferably a predominantly poly(butadiene), block p and q each represent an integer of 1 or higher and the sum of which is in the range of from 3 to 20 and preferably from 4 to 8, and wherein X represents the residue of a polyfunctional coupling agent, any present poly(butadiene) blocks B and C in which having a 1,2-polymerization degree of from 20% to 75% of the originally present butadiene; and each of the poly(conjugated diene) blocks having an apparent molecular weight in the range of from 30,000 to 150,000, and the blocks B and C representing from 65 to 93% by weight of the total block copolymer weight;
(b) from 0.1 to 5 pbw of at least one photoinitiator, selected from the group consisting of:
   (1) a benzophenone of the general formula (I) 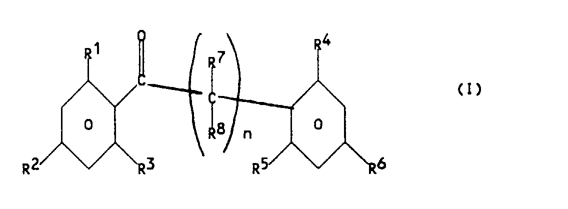 wherein R¹ to R⁶ independently represent hydrogen or an alkyl group having from 1 to 4 carbon atoms, preferably methyl, and wherein R⁷ and/or R⁸ have the same meaning as R¹ to R⁶ or represent in addition alkoxy of 1 to 4 carbon atoms and wherein n has a value of 0, 1 or 2, optionally in combination with at least one tertiary amine;
   (2) a compound of the general formula II 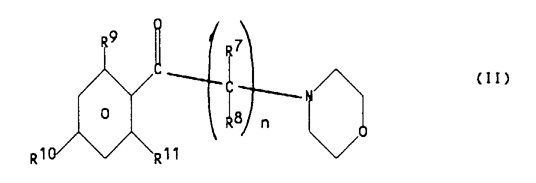 wherein R⁹, R¹⁰ and R¹¹ each may represent hydrogen, alkyl of 1 to 4 carbon atoms, or an alkylthio having 1 to 4 carbon atoms, while at least one of substituents R⁹, R¹⁰ and R¹¹ represents alkylthio, wherein n has a value of 0, 1 or 2,
   (3) and mixtures of (1) and (2).

   With the expression "apparent molecular weight" as used throughout the specification is meant the molecular weight as determined by Gel Permeation Chromatography using poly(styrene) calibration standards of different molecular weights.
   It will be appreciated that the respective blocks A and/or B and/or C in the total block copolymer configuration may be composed of the same or different monomers. The blocks B and/or C may optionally be selectively hydrogenated partially, the remaining ethylenical unsaturation of the total ethylenical unsaturation being in the range from 50 to 20% of the original unsaturation.
   With the term "predominantly" as used throughout the present specification is meant that the respective blocks may be constituted by a main monomer and a minor monomer, which may be structurally similar to the major monomer or may be structurally different from the main monomer and may occur in an amount of up to 10 wt% and preferably up to 5 wt%, relative to the total weight of comonomers of said block.
   The monovinylaromatic monomer as major component in block A and optional minor component in blocks B and/or C may be selected from styrene, ∝-methylstyrene, o-methylstyrene, p-methylstyrene, p-tert-butylstyrene, 1,3-dimethylstyrene or mixtures thereof. Styrene is the most preferred monomer.
   The conjugated diene to be used as major ingredient in blocks B and/or C is butadiene and/or isoprene which may be mixed with small amounts of 2,3-dimethyl 1,3,butadiene; 1,3-pentadiene 1,3-hexadiene or mixtures thereof, and of styrene, α-methylstyrene, o-methylstyrene, methylstyrene, p-methylstyrene, p-tertbutylstyrene, or mixtures thereof. However, pure 1,3 butadiene or pure isoprene for each block B and/or C are the most preferred monomers.
   As preferred component (a) multi-armed block copolymers, containing pure poly(butadiene and/or isoprene) blocks, pure poly(styrene) blocks or combinations of said blocks are used.
   The content of 1,2-polymerized conjugated diene in the B and C blocks of the block copolymer component (a) when poly(butadiene) is preferably in the range of from 35 to 65% and more preferably from 50 to 60%. The apparent molecular weight of each of the predominantly poly(conjugated diene) blocks is preferably in the range of from 40,000 to 120,000 and more preferably from 50,000 to 90,000.
   Each of the predominantly poly(monovinylaromatic) blocks have an apparent molecular weight in the range of from 5000 to 50,000 and preferably in the range of from 7000 to 35,000 and more preferably of from 9,000 to 17,000.
   According to a much preferred embodiment, radial block copolymers (AB)ₚ(C)_{q}X are used wherein the weight average molecular weight of the blocks B and C are substantially the same.
   The block copolymers to be used in the photocurable compositions as specified hereinbefore, can be prepared by methods known per se, such as disclosed in e.g. PCT application WO 93/24547; Polymer Preprints 26(1), 1985, p 247-248, European patent applications Nos. 0298667 and 0314256.
   Examples of suitable polyfunctional coupling agents can be SiCl₄, 1,2-bis(trimethoxysilyl)ethane (BTMSE), γ-glycidoxypropyl trimethoxysilane (GPTS), di-ethyladipate (DEAP), tetramethoxysilane (TMS), Cl₃Si-(CH₂)ₙ-SiCl₃, such as 1,2-bis(trichlorosilyl)ethane (BTCSE), (RO)₃Si-(CH₂)ₙ- Si(OR)₃ such as BTMSE, RCl₂Si-(CH)ₙ-SiCl₂R, Cl₃-SiSi-Cl₃, Cl₃Si-O-SiCl₃; RCl₂Si-(CH₂)ₙ-SiCl₂-(CH₂)ₙ-SiCl₂R, R-C(CH₂SiCl₃)₃; C(CH₂-SiCl₃)₄ and the like.
   It will be appreciated that the radial or branched block copolymers used as component (a) of the photo-curable polymer composition will contain a minor amount of diblock or homopolymer, which formed the initially prepared constituting elements before coupling.
   Examples of suitable compounds of category (1) are benzophenone, 2,4,6-trimethylbenzophenone, 4-methylbenzophenone, an eutectic mixture of 2,4,6-trimethylbenzophenone and 4-methylbenzophenone (ESACURE TZT) or 2,2-dimethoxy-1,2-diphenylethan-1-one (IRGACURE 651) (ESACURE and IRGACURE are trade marks). These compounds may be employed in combination with tertiary amines, such as e.g. UVECRYL 7100 (UVECRYL is a trade mark).
   Category (2) embraces compounds such as e.g. 2-methyl-1-[4-(methylthio)phenyl]-2-morpholinopropanone-1, commercially available as IRGACURE 907.
   In a preferred embodiment of the present invention the photoinitiator is selected from the group consisting of (i) benzophenone or 2,2-dimethoxy-1,2-diphenylethan-1-one (IRGACURE 651), and (ii) 2-methyl-1-[4-(methylthio)phenyl]-2-morpholinopropanone-1 (IRGACURE 907) or mixtures of one or both of these components with other members of groups (1) and (2).
   Most preferred is the use of 2,2 dimethoxy-1,2-diphenylethan-1-one (IRGACURE 651) or 2-methyll-[4-(methylthio)phenyl] 2-morpholinopropane (IRGACURE 907) as single photosensitizer.
   The photoinitiator should be present in an amount of from 0.1 to 5 parts by weight per 100 parts by weight of block copolymer (phr) to ensure sufficient cross-linking upon exposure to UV irradiation. It is preferred that the photoinitiator is present in an amount of from 0.5 and 2 phr.
   The UV irradiation used for cross-linking the block copolymer composition of the present invention in principle may be any UV source having an output spectra showing one or more peaks at wavelengths between 200 and 500 nanometer (nm) and preferably in the range from 230 to 450. Particularly suitable UV sources are Fusion bulb lamps (Fusion is a trade mark) having output maxima at 260-270 nm, 320 nm and 360 nm ("H" bulb), at 350-390 nm ("D" bulb) or at 400-430 nm ("V" bulb). Combinations of these Fusion bulb lamps may also be used. H and D bulb lamps are particularly useful, while a combination of D bulb and H bulb can also be suitably applied.
   The exposure to UV irradiation may be performed by any known method. A suitable method for instance is exposing a sample either in a layer obtained from a hot melt or in a layer obtained by solvent coating to UV irradiation by exposure through a negative placed between the light source and the photosensitive surface underneath. If necessary, the exposure to irradiation may be repeated one or more times, e.g. by repeatedly irradiating the sample layer underneath the UV source in order to accomplish a sufficient curing, providing sharply contrasted printing pictures.
   The photocurable and in particular UV curable block copolymer compositions according to the present invention can be suitably applied as hot melt or as solution in an organic solvent.
   It will be appreciated that in addition to the two hereinbefore specified main ingredients the photocurable polymer compositions may comprise one or more of the following optional ingredients
(c) 0.1-3 phr of an antioxidant/UV stabibilizer,
(d) 0-80 phr of a plasticizer,
(e) 0-300 phr of an organic solvent relative to the weight of block copolymer.

If any plasticizer is used, it is used in an amount of from 20 to 60 phr.

Examples of a suitable solvent are methylisobutylketone, cyclohexane, or cyclopentane, methylethylketone, n-hexane, isopentane or mixtures thereof.

It will be appreciated that for most flexographic printing plate preparations, hot melt compositions will be preferably used and no solvent at all.

As component (c) any antioxidant commonly applied in block copolymer formulations, may be used in the present compositions.

Examples of such antioxidants/stabilizers are those marketed under the trademarks IRGANOX and SUMILIZER e.g. IRGANOX 1010 and TNPP and the like.

As component (d) can be suitably used, as plasticizer for the poly(conjugated diene) blocks if any, both naphthenic and paraffinic oils, or low molecular weight polybutylene or poly(butadiene) polymers. Examples of suitable plasticizers are SHELLFLEX 371 and 451 and TUFFLO 6204 (naphthenic oils), TUFFLO 6056 (paraffinic oil), and the low molecular polybutylenes HYVIS 200, NAPVIS 30 and NAPVIS D-10, (SHELLFLEX, TUFFLO, HYVIS and NAPVIS are trademarks).

Other useful plasticizers for poly (conjugated diene) blocks are REGALREZ 1018, ONDINA 68 or ONDINA G 33 and V-OIL 7047 (REGALREZ, ONDINA and V-OIL are trademarks).

Useful plasticizers for the poly (mono vinyl aromatic) blocks are selected from lower molecular weight polystyrene (Mw< 3000) and copolymers of styrene, α-methyl styrene and other vinyl aromatic monomers, such as ENDEX 160, KRISTALEX F85, KRISTALEX 5140, PICCOLASTIC A75 (ENDEX, KRISTALEX and PICCOLASTIC are trademarks).

Also reactive esters of ethylenically unsaturated acids can be used in small amounts as a plasticizer, which is compatible with the poly(monovinyl aromatic) blocks.

The photocurable block copolymer compositions may be applied on a carrier in the form of a hot melt composition or in a solution of an organic solvent.

It will be appreciated that both types of application forms form also aspects of the present invention. Another aspect of the invention is formed by cured compositions in the form of flexographic printing plates, obtained by exposing the applied composition layer to UV irradiation.

The photocurable compositions can be applied as layers of the desired thickness.

For example the layers of these compositions can be derived from solutions in suitable solvents or from hot melt compositions, by pouring an appropriate layer on the support. In alternative ways said layers can be prepared by hot pressing, extrusion and calandering.

The layer thickness may normally vary depending on the final application purpose; for photosensitive recording elements such as flexographic printing plates it can vary in the range of from 0.01 to 50 mm and preferably from 1 to 6.5 mm thickness.

As layer support for these photosensitive compositions can be used any flexible material such as foil from polyethylene-terephthalate, polybutylene terephthalate, having a sufficiently high elasticity modulus, which can be used as dimensionally stable transparent support material and which are resistant to washout solutions.

It may be desirable to protect the photosensitive surfaces from contamination by dirt and dust during storage before being exposed and washed. Such protection may be accomplished by application of a flexible protective cover sheet to the side of the photocurable composition opposite that of the support. In addition, the photocurable compositions can sometimes be tacky and in such case it may be desirable to apply a release film to the surface of the photosensitive layer before application of the cover sheet. The release film may consist of a thin flexible, developing solvent dispersible polymeric film placed in intimate contact on the surface of the photocurable composition. Such release films are well known in the art.

Photosensitive articles comprising a support having a solid layer or surface comprising the photocurable compositions of the present invention, e.g. solid flexographic printing plates, can be processed by well known techniques for imagewise exposure to actinic light. Exposure takes place through a transparent support layer to form a continuous cured undersurface of the layer and subsequently through a negative placed between the light source and the photosensitive top surface.

Exposure periods depend upon the intensity of the actinic light, thickness of the plate, and the depth of the relief desired on the printing plate. Exposure periods of from 1 second to 20 minutes are generally suitable. After exposures and removal of the negative, the unexposed areas of the photosensitive surface can be developed in washout solutions as herein described. Imaged plates made with the hereinbefore specified block copolymers may be washed with organic solvents e.g. hexane or methylethylketone, optionally mixed with a lower alkanol such as methanol, ethanol, isopropanol or butanol.

It will be appreciated that the photocurable compositions and printing plates produced therewith are characterized by an attractive hardness in combination with other relevant physical properties as described below.

### Shore A Hardness

Shore A hardness is similar to modulus in that a polymer with a high hardness value will not conform easily to the analox roll or substrate, and ink transfer will be poor. Values in the range of about 35-70° are deemed desirable for flexographic printing application.

Herein resilience were determined by ASTM D 2632-79; and Shore A hardness by ASTM D 2240.

It will be appreciated, that photocurable compositions according to the present invention surprisingly have been found to provide flexographic printing plates which have the required properties and in particular a relatively low hardness (even without plasticizer) by curing without the presence or in the presence of only small amounts of unsaturated monomers to have adapted the final hardness.

The invention is further illustrated by the following examples, however without restricting the scope of the invention to these specific embodiments.
(A) Photocurable compositions were prepared from 100 parts by weight of the block copolymers, derived from styrene and butadiene, specified in the table 1, 1 part by weight of the antioxidant IRGANOX 1010 and 2 parts by weight of the photoinitiator IRGACURE 651.

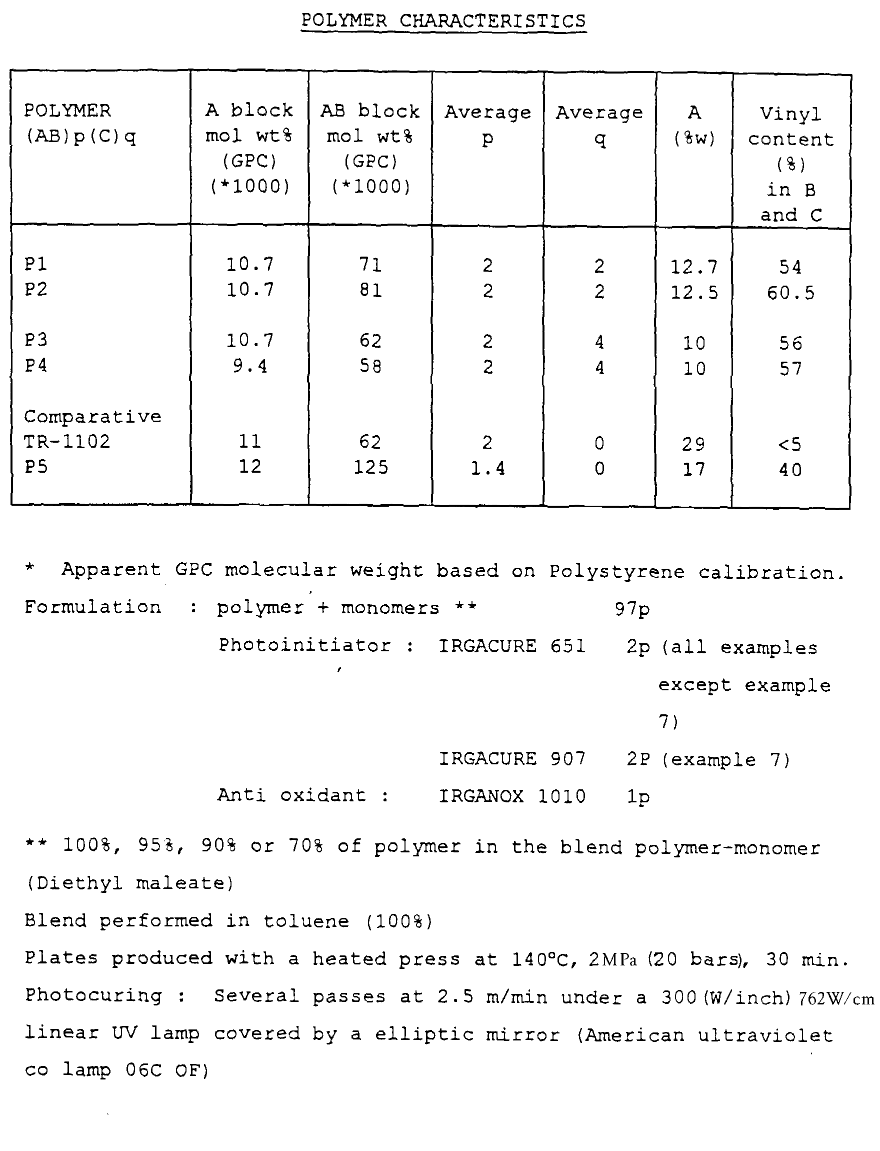

### Results:

| EXAMPLES | | | | | | | |
|---|---|---|---|---|---|---|---|
| Example | Polymer | Shore A hardness before curing | Thickness (mm) | Number of curing passes | Shore A hardness after curing | Gel content (%) | Swell ratio |
| 1 | P1 (100%) | 28 | 2.5 | 10 | 39 | 84 | 9.8 |
| | | | | | | | |
| 2 | P2 (100%) | 30 | 3.0 | 10 | 53 | 94 | 7.5 |
| | | | | | | | |
| 3 | P3 (100%) | 16 | 2.1 | 5 10 | 31 46 | 91 96 | 12.1 5.9 |
| | | | | | | | |
| 4 | P3 (95) | 16 | 2.0 | 5 10 | 32 41 | 92 95 | 11.4 6.0 |
| | | | | | | | |
| 5 | P3 (90%) | 14 | 2.1 | 5 10 | 33 39 | 91 95 | 12.5 5.6 |
| | | | | | | | |
| 6 | P4 (100%) | 17 | 2.2 | 10 | 39 | 96 | 7.7 |
| | | | | | | | |
| 7 | P2 (100%) | 29 | 3.0 | 10 | 47 | 90 | 12 |
| Compar. 8 | TR-1102 (100%) | 69 | 2.2 | 10 | 70 | 85 | 17.4 |
| | | | | | | | |
| Compar. 9 | P5 (100%) | 50 | 2.1 | 10 | 62 | 91 | 8.9 |

The Shore A hardness is measured after 3s.

The gel content (%) is expressed as the weight ratio of the dried extracted gel (after dissolution in toluene 100%) by the corresponding sample before dissolution.

The swelling ratio is expressed as the weight ratio of the swelled gel (in toluene 100%) by the corresponding dried gel (dried to constant weight under vacuum).

## Claims

1. Flexographic printing plates, obtainable by exposing to UV irradiation a layer of a photocurable elastomer composition, comprising at least
(a) 100 parts by weight (pbw) of a block copolymer containing at least three poly(conjugated diene) blocks and at least one block selected from poly(monovinylaromatic) blocks, and having a branched or radial structure, of the general formula [AB]ₚ[C]_{q}X wherein each A represents a predominantly poly(monovinyl- aromatic) block, each B and C represent a predominantly poly(conjugated diene) block, p and q each represent an integer of 1 or higher and the sum of which is in the range of from 3 to 20, and wherein X represents the residue of a polyfunctional coupling agent, any present poly(butadiene) blocks B and C in which having a 1,2-polymerization degree of from 20% to 75% of the originally present butadiene and each of the poly(conjugated diene) blocks having an apparent molecular weight in the range of from 30,000 to 150,000; and the blocks B and C representing from 65 to 93% by weight of the total block copolymer weight;
(b) from 0.1 to 5 pbw of at least one photoinitiator, selected from the group consisting of:
(1) a benzophenone of the general formula (I) 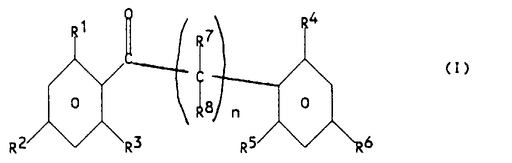 wherein R¹ to R⁶ independently represent hydrogen or an alkyl group having from 1 to 4 carbon atoms, preferably methyl, and wherein R⁷ and/or R⁸ have the same meaning as R¹ to R⁶ or represent in addition alkoxy of 1 to 4 carbon atoms and wherein n has a value of 0, 1 or 2, optionally in combination with at least one tertiary amine,
(2) a compound of formula II 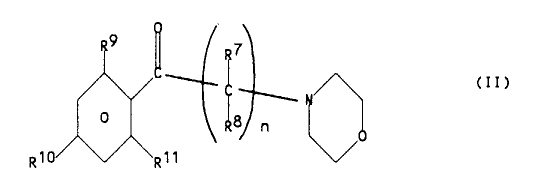 wherein R⁹, R¹⁰ and R¹¹ each may represent hydrogen, alkyl of 1 to 4 carbon atoms, or an alkylthio having 1 to 4 carbon atoms, while at least one of the substituents R₉, R₁₀ and R₁₁ represent an alkylthiol, wherein n has a value of 0, 1 or 2,
(3) and mixtures of (1) and (2).

2. Flexographic printing plates according to claim 1, characterized in that component (a) of the photocurable composition is consisting of a multi-armed block copolymer, containing pure poly(styrene) blocks and pure poly(butadiene) and/or poly(isoprene) blocks or combinations of said blocks.

3. Flexographic printing plates according to claims 1 and 2 characterised in that the sum of p and q in the block copolymer component (a) is in the range from 4 to 8.

4. Flexographic printing plates according to claims 1-3, characterized in that the content of 1,2-polymerised conjugated diene in the total block copolymer component (a) is in the range of from 35 to 65%.

5. Flexographic printing plates according to claims 1-4, characterized in that the predominantly poly(monovinyl aromatic) blocks in component (a) of the photocurable composition have an apparent molecular weight in the range of from 9000 to 17,000.

6. Flexographic printing plates according to claims 1-5 characterized in that component (b) is comprising 2-methyl-1-[4-(methylthio)-phenyl]-2-morpholinopropanone-1 or 2,2-dimethoxy-1,2-diphenylethan-1-one.

7. Flexographic printing plates according to claims 1-6 characterized in that the photocurable compositions is applied in a layer of from 0.01 to 6.5 mm thickness on a layer support of a transparent flexible material.

## Patentansprüche

1. Flexodruckplatten, die durch Einwirken von UV-Bestrahlung auf eine Schicht einer photohärtbaren Elastomerzusammensetzung erhältlich sind, welche Zusammensetzung zumindest
(a) 100 Gewichtsteile (pbw) eines Blockcopolymers, das wenigstens drei Poly(konjugiertes Dien)blöcke und wenigstens einen unter Poly (monovinylaromat)blöcken ausgewählten Block enthält, und eine verzweigte oder radiale Struktur mit der allgemeinen Formel [AB]ₚ[C]_{q}X enthält, worin jedes A einen überwiegend Poly(monovinylaromat)block darstellt, jedes B und C einen vorwiegend Poly(konjugiertes Dien)block darstellen, p und q jeweils eine ganze Zahl von 1 oder höher bedeuten und die Summe davon im Bereich von 3 bis 20 liegt, und worin X den Rest eines polyfunktionellen Kupplungsmittels darstellt, wobei etwa vorliegende Poly(butadien)blöcke B und C einen 1,2-Polymerisationsgrad von 20 bis 75 % des ursprünglich vorliegenden Butadiens aufweisen, und wobei jeder der Poly(konjugiertes Dien)blöcke ein scheinbares Molekulargewicht im Bereich von 30.000 bis 150.000 zeigt und die Blöcke B und C 65 bis 93 Gew.-% des Blockcopolymer-Gesamtgewichtes ausmachen; und
(b) von 0,1 bis 5 pbw wenigstens eines Photoinitiators umfaßt, ausgewählt aus der Gruppe, die aus:
(1) einem Benzophenon mit der allgemeinen Formel (I) 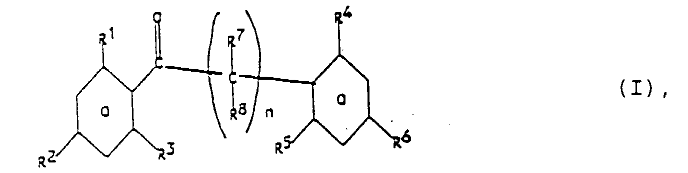 worin R¹ bis R⁶ unabhängig Wasserstoff oder eine Alkylgruppe mit 1 bis 4 Kohlenstoffatomen, vorzugsweise Methyl, bedeuten und worin R⁷ und/oder R⁸ die gleiche Bedeutung wie R¹ bis R⁶ aufweisen oder zusätzlich Alkoxy mit 1 bis 4 Kohlenstoffatomen darstellen und worin n einen Wert von 0, 1 oder 2 aufweist, gegebenenfalls in Kombination mit wenigstens einem tertiären Amin;
(2) einer Verbindung mit der allgemeinen Formel II 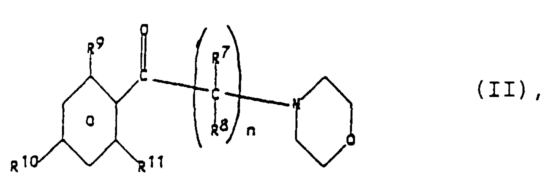 worin R⁹, R¹⁰ und R¹¹ jeweils Wasserstoff, Alkyl mit 1 bis 4 Kohlenstoffatomen oder Alkylthio mit 1 bis 4 Kohlenstoffatomen darstellen können, während wenigstens einer der Substituenten R⁹, R¹⁰ und R¹¹ für Alkylthio steht, worin n einen Wert von 0, 1 oder 2 aufweist,
(3) und Gemischen von (1) mit (2) besteht.

2. Flexodruckplatten nach Anspruch 1, dadurch gekennzeichnet, daß die Komponente (a) der photohärtbaren Zusammensetzung aus einem mehrarmigen Blockcopolymer besteht, das reine Poly(styrol)blöcke und reine Poly(butadien)- und/oder Poly(isopren)blöcke oder Kombinationen dieser Blöcke enthält.

3. Flexodruckplatten nach den Ansprüchen 1 und 2, dadurch gekennzeichnet, daß die Summe aus p und q in der Blockcopolymerkomponente (a) im Bereich von 4 bis 8 liegt.

4. Flexodruckplatten nach den Ansprüchen 1 bis 3, dadurch gekennzeichnet, daß der Gehalt an 1,2-polymerisiertem konjugiertem Dien in der Blockcopolymergesamtkomponente (a) im Bereich von 35 bis 65 % liegt.

5. Flexodruckplatten nach den Ansprüchen 1 bis 4, dadurch gekennzeichnet, daß die überwiegend Poly(monovinylaromat)blöcke in der Komponente (a) der photohärtbaren Zusammensetzung ein scheinbares Molekulargewicht im Bereich von 9.000 bis 17.000 aufweisen.

6. Flexodruckplatten nach den Ansprüchen 1 bis 5, dadurch gekennzeichnet, daß die Komponente (b) 2-Methyl-1-[4-(methylthio)-phenyl] -2-morpholinopropanon-1 oder 2,2-Dimethoxy-1,2-diphenylethan-1-on umfaßt.

7. Flexodruckplatten nach den Ansprüchen 1 bis 6, dadurch gekennzeichnet, daß die photohärtbare Zusammensetzung in einer Schicht von 0,01 bis 6,5 mm Stärke auf eine Trägerschicht aus einem durchsichtigen biegsamen Material aufgetragen ist.

## Revendications

1. Plaques d'impression flexographique, que l'on peut obtenir par l'exposition à un rayonnement UV, d'une composition d'élastomère photodurcissable, comprenant au moins
(a) 100 parties en poids (pep) d'un copolymère séquencé contenant au moins trois séquences de poly(diène conjugué) et au moins une séquence choisie parmi une séquence poly(monovinylaromatique) et possédant une structure ramifiée ou radiale, de la formule générale [AB]ₚ[C]_{q}X dans laquelle A représente une séquence poly(monovinylaromatique) en prédominance, B et C représentent une séquence de poly(diène conjugué) en prédominance et, de préférence, de poly(butadiène) en prédominance, p et q représentent chacun un nombre entier égal à 1 ou à plus de 1 et dont la somme varie de 3 à 20 et dans laquelle X représente le reste d'un agent de couplage polyfonctionnel, n'importe quelles séquences de poly(butadiène) B et C présentes possédant un degré de polymérisation-1,2 de 20% à 75% du butadiène présent à l'origine et chacune des séquences de poly(diène conjugué) possédant un poids moléculaire apparent qui fluctue de 30.000 à 150.000 et les séquences B et C représentent de 65 à 93% en poids du poids du copolymère séquencé total,
(b) de 0,1 à 5 pep d'au moins un photoamorceur, choisi dans le groupe constitué de :
(1) une benzophénone de la formule générale (I) 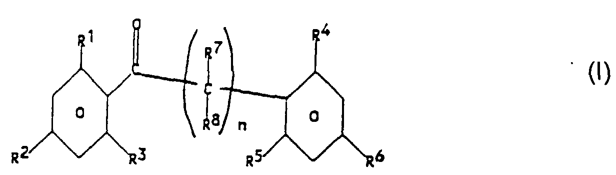 dans laquelle R¹ à R⁶ représentent indépendamment de l'hydrogène ou un radical alkyle possédant de 1 à 4 atomes de carbone, de préférence, le radical méthyle et dans laquelle R⁷ et/ou R⁸ ont les mêmes significations que R¹ à R⁶, ou représentent en outre des radicaux alcoxy possédant de 1 à 4 atomes de carbone et dans laquelle n a une valeur égale à 0, 1 ou 2, éventuellement, en combinaison avec au moins une amine tertiaire,
(2) un composé de la formule générale II 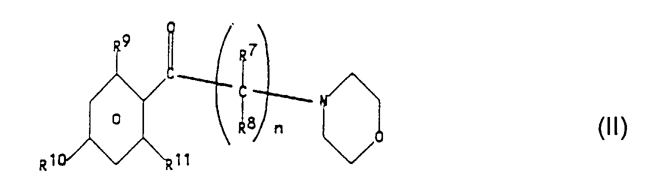 dans laquelle R⁹, R¹⁰ et R¹¹ peuvent chacun représenter un atome d'hydrogène, un radical alkyle possédant de 1 à 4 atomes de carbone, ou un radical alkylthio possédant de 1 à 4 atomes de carbone, tandis qu'au moins l'un des substituants R⁹, R¹⁰ et R¹¹ représente un groupe alkylthio, dans laquelle n a une valeur égale à 0, 1 ou 2 et
(3) des mélanges de (1) et de (2).

2. Clichés d'impression flexographique suivant la revendication 1, caractérisés en ce que le composant (a) de la composition photodurcissable est constitué d'un copolymère séquencé à bras multiples, contenant des séquences de poly(styrène) pur et des séquences de poly(butadiène) et/ou de poly(isoprène) purs, ou de combinaisons des séquences précitées.

3. Clichés d'impression flexographique suivant les revendications 1 et 2, caractérisés en ce que la somme de p et de q dans le composant à base de copolymère séquencé (a) varie de 4 à 8.

4. Clichés d'impression flexographique suivant l'une quelconque des revendications 1 à 3, caractérisés en ce que la teneur en diène conjugué 1,2-polymérisé dans le composant à base de copolymère séquencé total (a) varie de 35 à 65%.

5. Clichés d'impression flexographique suivant l'une quelconque des revendications 1 à 4, caractérisés en ce que les séquences poly(monovinylaromatiques) en prédominance dans le composant (a) de la composition photodurcissable possèdent un poids moléculaire apparent, qui varie de 9.000 à 17.000.

6. Clichés d'impression flexographique suivant l'une quelconque des revendications 1 à 5, caractérisés en ce que le composant (b) est la 2-méthyl-1-[4-(méthylthio)phényl]-2-morpholino-1 ou la 2,2-diméthoxy-1,2-diphényléthane-1-one.

7. Clichés d'impression flexographique suivant l'une quelconque des revendications 1 à 6, caractérisés en ce que l'on applique les compositions photodurcissables en une couche d'une épaisseur de 0,01 à 6,5 mm, sur une couche de support d'un matériau souple et transparent.
